# EUROPEAN PATENT SPECIFICATION

(11) **EP 1 634 375 B1**
(45) Date of publication and mention of the grant of the patent: **24.01.2007**
(21) Application number: 04787070.4
(22) Date of filing: 30.09.2004
(51) Int. Cl.: H03L 7/081, H03K 5/13

(54) **DELAYED LOCKED LOOP PHASE BLENDER CIRCUIT**
PHASENMISCHSCHALTUNG MIT VERZÖGERTEM REGELKREIS
CIRCUIT MELANGEUR DE PHASE A BOUCLE A VERROUILLAGE DE RETARD

(30) Priority: 30.10.2003 US 696920
(43) Date of publication of application: 15.03.2006
(73) Proprietor: Infineon Technologies AG, 81669 München (DE)
(72) Inventor: HAN, Jonghee, Cary, North Carolina 27513 (US); KIM, Jung, Pill, Cary, North Carolina 27519 (US)
(74) Representative: Schoppe, Fritz
(86) International application number: PCT/EP2004/010941
(87) International publication number: WO 2005/048455

(56) References cited:
- EP-A- 0 575 691
- US-A- 6 115 439
- US-A1- 2003 128 059

## Description

### BACKGROUND OF THE INVENTION

### Field of the Invention

The present invention generally relates to integrated circuit devices and, more particularly to delay locked loops utilized in integrated circuit devices.

### Description of the Related Art

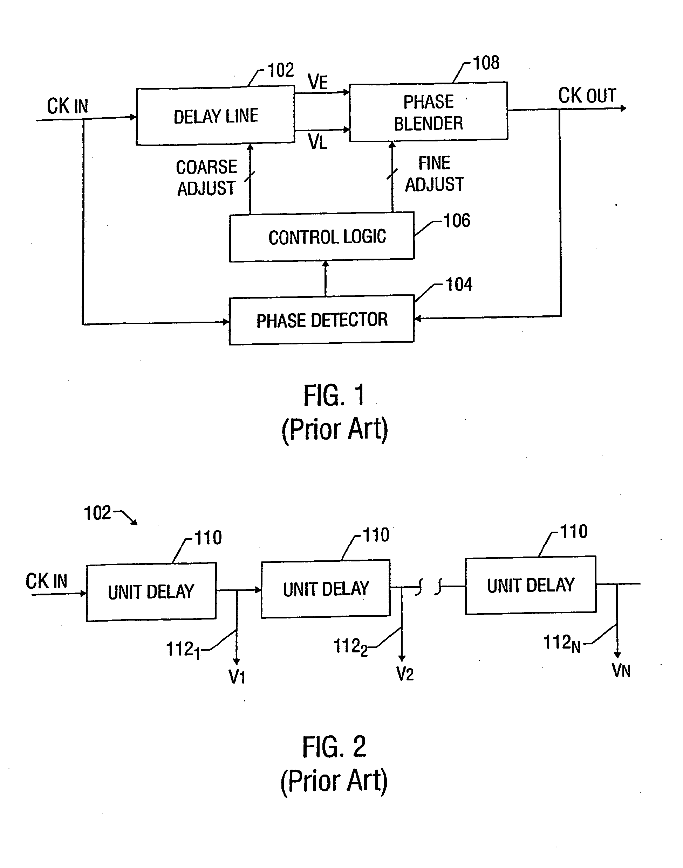

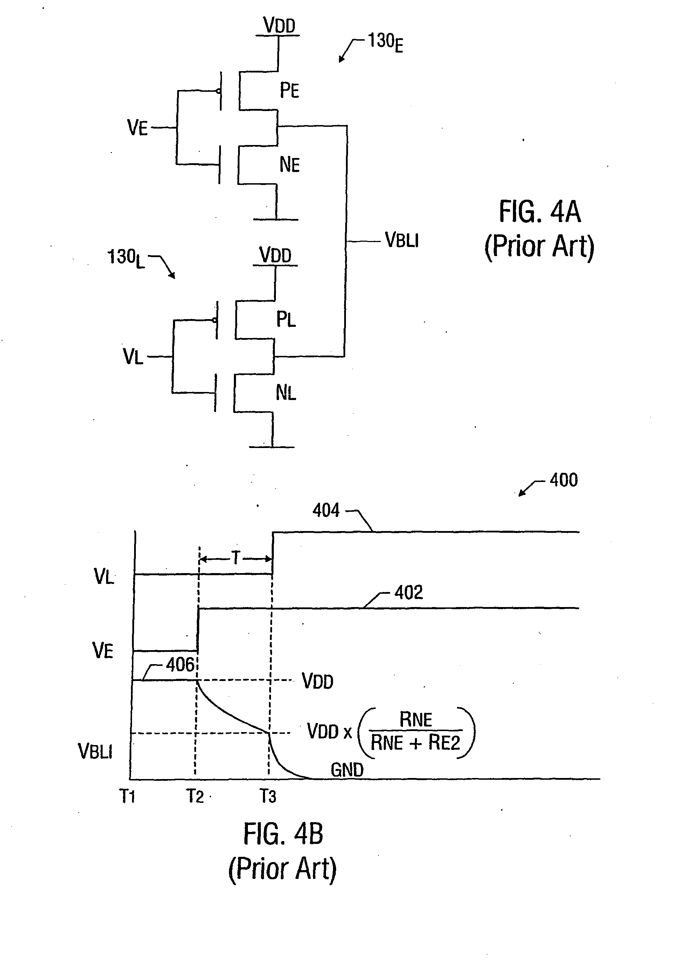

Delay locked loops (DLL) are utilized in a wide variety of integrated circuit (IC) devices to synchronize output signals with periodic input signals. In other words, the objective of the DLL is to adjust the phase difference between the input and output signals near zero. FIG. 1 illustrates an exemplary DLL circuit 100 configured to synchronize an output clock signal CK_{OUT} with an input clock signal CK_{IN}.

As illustrated, the DLL circuit 100 generally includes a delay line 102, phase detector 104, control logic 106 and a phase blender 108. The phase detector 104 compares the phase of CK_{OUT} to CK_{IN}, and generates a signal to the control logic 106, which adjusts the delay line 102 and phase blender 108, based on the detected phase difference. The control logic 106 may include any suitable circuitry, such as shift registers, or any other type registers, to control the delay line 102 and phase blender 108 to delay CK_{IN} sufficiently to synchronize CK_{OUT}. In other words, the control logic 106 may control the delay line 102 and phase blender 108, such that the delay between CK_{IN} and CK_{OUT} is substantially equal to a multiple of their clock period.

As illustrated in FIG. 2, the delay line 102 may include many delay blocks 110, each representing a single unit delay. Taps 112 may be provided between each delay block 110, allowing different delayed versions of CK_{IN} to be selected. For example, the signal V₁ on tap 112₁ corresponds to CK_{IN} delayed by one unit delay. Therefore, the total delay through the delay line 102 may be controlled by selecting the appropriate tap(s) 112 for output from the delay line 102. Typically, the unit delay is equal to the propagation delay of one or two inverters used in the delay block 110.

Unfortunately, this unit delay time may be too coarse (large) to provide the phase resolution required to adequately synchronize CK_{IN} and CK_{OUT} for high speed applications. Thus, the phase blender 108 may be configured to provide finer phase adjustments than the unit delays of the delay line 102 will allow. As illustrated, the phase blender 108 may take, as input, early and late phase delayed signals V_{E} and V_{L}, respectively, typically separated by one unit delay. For example, V_{E} and V_{L} may be obtained from adjacent taps 112; and 112ᵢ₊₁, respectively, of the delay line 102. The phase blender 108 then generates an output signal (e.g., CK_{OUT} in this case) that has a intermediate (or "blended") phase between the phase of the signals V_{E} and V_{L}.

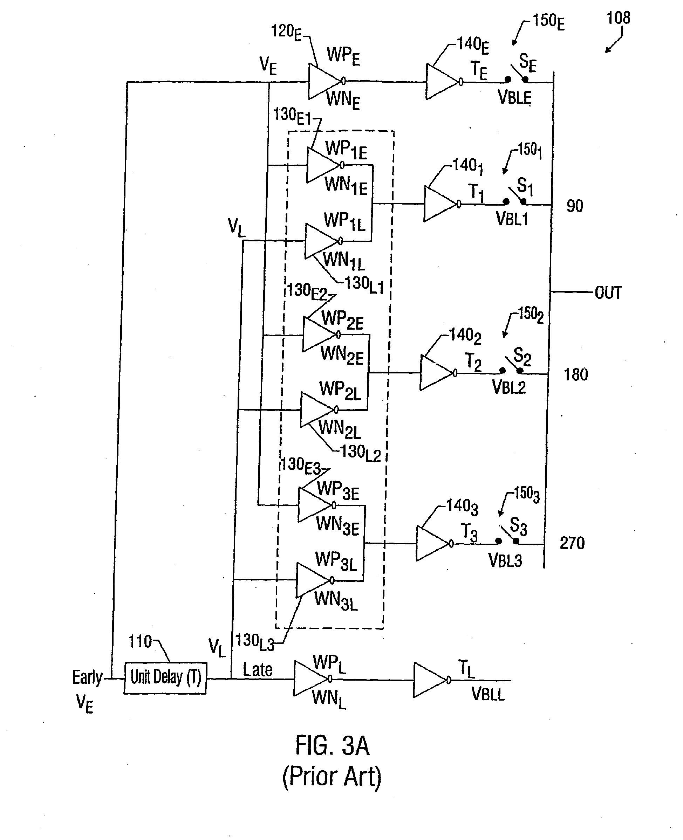

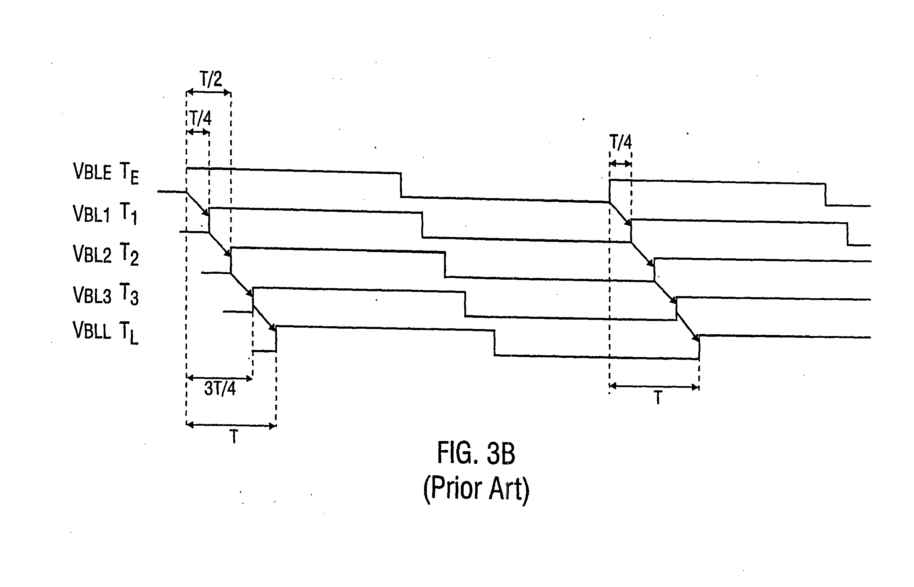

FIG. 3A illustrates an exemplary circuit configuration of a phase blender 108, configured to generate four signals separated in phase by approximately 90°. In other words, as illustrated in FIG. 3B, the signals are equally distributed by T/4, where T is the unit delay used in the delay line 102, which separates V_{E} and V_{L}.
The desired signal may be selected for output via switches 150, for example, controlled by the control logic 106 shown in FIG. 1. As illustrated, signals V_{BL2}, V_{BL2}, and V_{BL3} may each be generated by blending V_{E} and V_{L} via a corresponding pair of blending inverters 130, with each pair including an inverter 130_{E} for receiving the early signal V_{E} and an inverter 130_{L} for receiving the late signal V_{L}. When the outputs of these blending inverters 130 reach the threshold level of comparators 140₁₋₃, the output signals V_{BL2}, V_{BL2}, and V_{BL3} are generated.

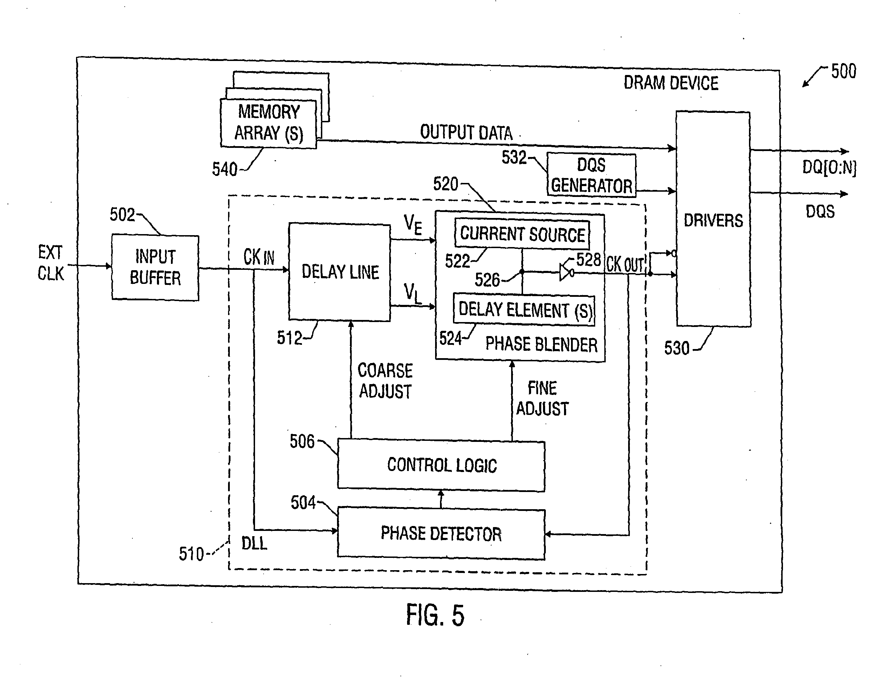

Generating a blended phase signal may be described with reference to the transistor representation of a pair of blending inverters 130 shown in FIG. 4A and the corresponding timing diagram of FIG. 4B. At T1, both V_{E} and V_{L} are low, and both PMOS transistors PE and PL of inverters 130_{E} and 130_{L} are switched on, while NMOS transistors NE and NL of inverters 130_{E} and 130_{L} are switched off. As a result, the (inverted) output V_{BLI} is initially a logic high.

At T2, the early signal V_{E} is asserted, switching PE off and NE on, while PL remains on. Thus, the voltage level of V_{BLI} is determined by the transistor on-resistances (current drive) of PL and NE. At T3, one unit delay after V_{E} is asserted, V_{L} is asserted, switching PL off and NL on, thus driving the V_{BLI} to the full logic low level. While not shown, similar switching occurs when V_{E} and V_{L} are de-asserted. For example, when V_{E} is de-asserted, PE is switched on and NE is switched off, while NL remains on, the voltage level of V_{BLI} is determined by the transistor on-resistances (current drive) of PE and NL. Finally, V_{L} is de-asserted, switching PL on and NL off, thus returning V_{BLI} to the full logic high level.

In general, the stronger the drive current for the early inverter 130_{E} relative to the late inverter 130_{L}, the smaller delay between V_{BLI} and V_{E}. Thus, the relative drive currents of each pair of blending inverters 130 may be varied (e.g., by varying the ratio of the device widths) to achieve the different phase signals. As an example, to generate V_{BL1} only T/4 latter than V_{E}, the device widths of the early inverter 130_{E} should be greater than the device widths of the late inverter130_{L}. To generate V_{BL2} T/2 later than V_{E}, the device widths of the early and later inverters should be approximately the same. To generate V_{BL3} 3*T/4 from V_{E}, the device widths of the later inverter 130_{L} should be greater than the device widths of the early inverter 130_{E}.

While this type of blending circuit provides for fine phase adjustment of signals from the delay line 102, the circuit suffers from a number of disadvantages. For example, determining the sizes of blending inverters with adequate precision to generate phase signals having a desired resolution can be a difficult task. Moreover, as illustrated in FIG. 3A, each pair of phase blending inverters 130 has one or more current sources (e.g., PE and PL) and its own comparator 140. While the illustrated example has only four outputs, a real application may have several more outputs, or several cascaded stages. As a result, the large number of inverters and comparators may consume a significant amount of current.
US-A-6,115,439 discloses a free-running digital phase-lock loop having a variable delay element. A coarse-delay line is formed by a plurality of delay elements and by means of a switch the input side of a selected delay element as well as the output side of the selected delay element is connected to a fine delay element to provide a first signal and a second signal to the fine delay element. The first signal is provided to a buffer and parallel to this buffer a plurality of capacitors can be switched by means of a control signal. Likewise, the second signal is applied to a buffer to which also a plurality of capacitors can be switched in parallel. The two lines are connected at a commutator for passing the edge of a clock signal, which arrives first. Each of the capacitors slightly increases the delay of the propagation through the delay path.
It is the object of the present invention to provide improved techniques and circuit configurations for the fine adjustment of a signal generated by a DLL circuit.
This object is achieved by a phase blending circuit of claim 1, and by a method of claim 15.
In accordance with a further aspect, the present invention provides a delay locked loop circuit comprising the inventive phase blending circuit.
In accordance with yet a further aspect, the present invention provides a dynamic random access memory comprising the delay locked loop circuit having the inventive phase blending circuit.

### SUMMARY OF THE INVENTION

Embodiments of the present invention generally provide improved techniques and circuit configurations for the fine adjustment of a signal generate by a DLL circuit.

One embodiment provides a phase blending circuit for generating a plurality of signals differing in phase relative to an early phase signal. The phase blending circuit generally includes a current source having a common output node, one or more delay elements, and one or more switches to selectively couple one or more of the delay elements to the common output node of the current source, wherein a time required for a voltage level at the common output node to fall below a threshold level after assertion of the early phase signal is dependent on which of the one or more delay elements are coupled to the common output node.

Another embodiment provides a phase blending circuit for generating a plurality of signals differing in phase relative to an early phase signal. The phase blending circuit generally includes a current source having a common output node and a control input for disabling the current source when a late phase signal trailing the early phase signal is asserted, a comparator having an input coupled with the common output node of the current source, a plurality of delay elements, a path for current flow from the common output node when the early phase signal is asserted, and a plurality of switches to selectively couple one or more of the delay elements to the output node of the current source for varying the time required for a voltage level of the common output node to fall below a threshold level as a result of current flow through the path.

Another embodiment provides a delay locked loop circuit for generating an output signal aligned with an input signal. The delay locked loop circuit generally includes a delay line for providing phase signals delayed relative to the input signal by one or more of unit delays, a phase blending circuit for generating a blended phase signal having a phase between early and late phase signals provided by the delay line, the phase blending circuit comprising a current source and one or more delay elements for selectively coupling to a common output node of the current source, wherein a time required for a voltage level at the common output node to fall below a threshold level after assertion of the early phase signal is dependent on which of the one or more delay elements are coupled to the common output node, and control logic configured to monitor skew between the input and output signals and, based on the skew, generate one or more control signals to select the early and late signals provided to the phase blending circuit and to selectively couple one or more of the delay elements to the common output node.

Another embodiment provides a dynamic random access memory (DRAM) device generally including a one or more memory elements and a delay locked loop circuit for synchronizing data output from the one or more memory elements with a clock signal. The delay locked loop circuit generally includes (i) a delay line, (ii) a phase blending circuit comprising a current source and one or more delay elements for selectively coupling to a common output node of the current source, wherein a time required for a voltage level at the common output node to fall below a threshold level after assertion of an early phase signal provided by the delay line is dependent on which of the one or more delay elements are coupled to the common output node, and (iii) control logic configured to monitor skew between the input and output signals and, based on the skew, generate one or more control signals to select the early signal provided to the phase blending circuit by the delay line and to selectively couple one or more of the delay elements to the common output node.

Another embodiment provides a method for generating a phase signal having a phase intermediate to phases of an early signal and a late signal. The method generally includes coupling the early signal to a control input of one or more switches to provide a path for current flow from a common output node of a current source through the one or more switches when the early signal is asserted and closing one or more switches to selectively couple one or more delay elements to the common output node of the current source, wherein a time required for a voltage level of the common output node to fall below a threshold level as a result of the current flow is dependent on which of the one or more switches are closed.

### BRIEF DESCRIPTION OF THE DRAWINGS

So that the manner in which the above recited features, advantages and objects of the present invention are attained and can be understood in detail, a more particular description of the invention, briefly summarized above, may be had by reference to the embodiments thereof which are illustrated in the appended drawings.

It is to be noted, however, that the appended drawings illustrate only typical embodiments of this invention and are therefore not to be considered limiting of its scope, for the invention may admit to other equally effective embodiments.

FIG. 1 illustrates an exemplary delay-locked loop (DLL) circuit

FIG. 2 illustrates an exemplary delay line in accordance with the prior art.

FIGs. 3A-3B illustrate an exemplary DLL blender circuit and corresponding timing diagram, respectively, in accordance with the prior art.

FIGs. 4A-4B illustrate an exemplary schematic of an inverter pair of the DLL blender circuit if FIG. 3 and a corresponding timing diagram, respectively.

FIG. 5 illustrate an exemplary dynamic random access memory (DRAM) device utilizing a dynamic locked loop (DLL) circuit in accordance with an embodiment of the present invention.

FIG. 6 is a flow diagram of exemplary operations for synchronizing input and output signals utilizing the DLL circuit of FIG. 5.

FIGs. 7A-7B illustrate an exemplary DLL blender circuit in accordance with an embodiment of the present invention.

FIG. 7C illustrates an exemplary timing diagram corresponding to the DLL blender circuit of FIGs. 7A-7B.

FIG. 8 illustrates an exemplary DLL blender circuit in accordance with another embodiment of the present invention.

### DETAILED DESCRIPTION OF THE PREFERRED EMBODIMENTS

Embodiments of the present invention generally provide improved techniques and circuit configurations for fine phase adjustments, for example, in a delay-locked loop (DLL) circuit. Rather than utilize one or more different current sources to generate each fine adjust phase signal as in the prior art (e.g., the transistors PE and PL in each pair of blending inverters 130 of FIG. 1), embodiments of the present invention may generate multiple phase signals from a single current source. To generate signals with different phases, different delay elements that vary the timing of a signal generated by switching the current source may be selectively coupled to the current source. As a result, circuit configurations of the present invention may be simpler to design, simpler to manufacture, occupy less real estate, and consume less current.

As used herein, the term current source generally refers to any type of device used to supply the necessary current to generate a signal, such as a switching transistor (e.g., a PFET or NFET) coupled to a source power supply line (e.g., V_{DD}). The techniques and circuit configurations described herein may be utilized in a wide variety of applications to adjust the phase of a generated signal. However, to facilitate understanding, the following description will refer to embodiments utilizing the techniques and circuit configurations in a DLL circuit of a dynamic random access memory (DRAM) as a particular, but not limiting application example.

### AN EXEMPLARY DRAM DEVICE

FIG. 5 illustrates an exemplary dynamic random access memory (DRAM) device 500 utilizing a dynamic locked loop (DLL) circuit 510 in accordance with an embodiment of the present invention. A typical requirement of DRAM specifications is that data from memory arrays 540 be available on output lines DQ[0:N] on the rising edge (and falling edge in double data rate devices) of an externally supplied clock signal (CLK). In some cases, the DRAM may supply a data strobe signal DQS, that should also be synchronized with CLK, indicating the data is available.

One approach to synchronize DQ or DQS with CLK would be to clock driver circuits 530 with CLK. However, a number of elements may contribute to a phase delay between CLK at the input of the device and CLK arriving at the driver circuit 530, such as an input buffer 502 and interconnection lines used to propagate CLK through the device 500. Variations in manufacturing processes, temperature, and operating clock frequencies may contribute to further delays. Thus, clocking the driver circuit 530 directly with CLK may be undesirable skew between CLK and DQ or DQS signals which may decrease the valid output data window.

However, the DLL circuit 510 may be used to synchronize the DQS and DQ signals with the CLK signal through the introduction of an artificial delay of CLK. Thus, the DLL circuit 510 may be used to increase the valid output data window by synchronizing the output of data with both the rising and falling edges of an output clock CK_{OUT} (in phase with CLK) used to clock the driver circuits 530. As illustrated, the DLL circuit 510 may include a delay line 512, phase detector 504, and control logic 506. As with conventional DLL circuits, the delay line 512 may include a chain of relatively coarse unit delays and may be used to make coarse phase adjustments, while the phase blender 520 may be used to make finer phase adjustments.

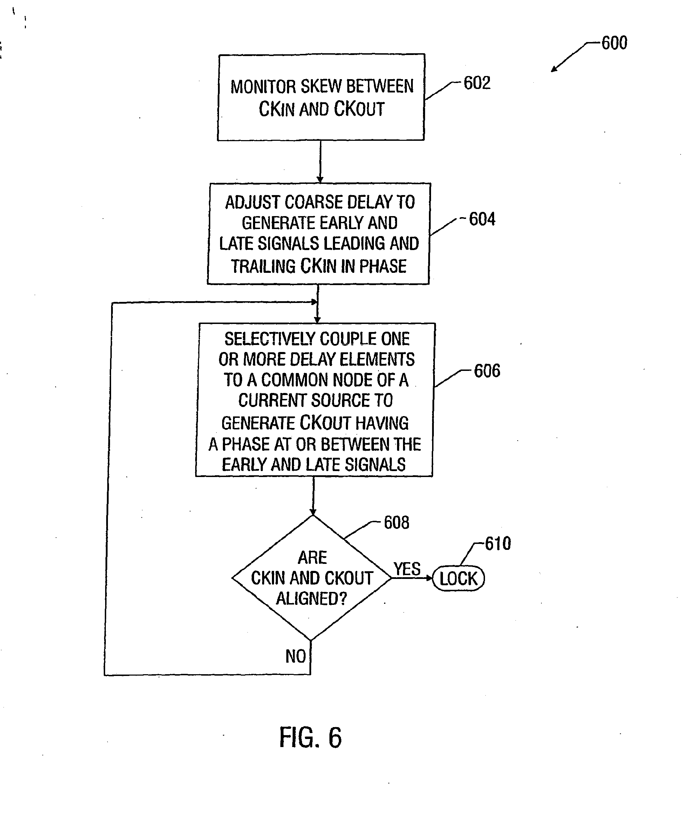

Operation of the DLL circuit 510 and phase blender 530 may be described with reference to FIG. 6, which illustrates a flow diagram of exemplary operations 600 for synchronizing input and output signals. For example, the operations 600 may be performed via the control logic 506 to control the delay line 512 and phase blender 530 during an initialization sequence of the DLL (e.g., power up or exiting a self-refresh mode). The operations 600 may also be performed continuously to make "run-time" adjustments to CK_{OUT}, for example, to compensate for changes in frequency to CLK or changes in delay thereof due to changing temperature.

In any case, the operations 600 begin at step 602, by monitoring skew (phase difference) between CK_{IN} and CK_{OUT}. For example, the control logic 506 may monitor one or more signals, generated by the phase detector 504, indicative of the phase difference between CK_{IN} and CK_{OUT}. At step 604, a coarse delay is adjusted to generate early and late signals leading and trailing CK_{IN} in phase. For example, the control logic 506 may generate one or more control signals to select adjacent taps of the delay line 512 to feed early and late signals V_{E} and V_{L} (e.g., differing in phase by one delay unit) to the phase blender 530.

At step 606, one or more delay elements are selectively coupled to a common node of a current source to generate CK_{OUT} having a phase at or between the early and late signals. For example, the phase blender 520 may include one or more delay elements 526, which may be selectively coupled to a common output node 526 of a current source 522. As will be described in greater detail below, the delay elements 524 may be used to vary the time required for a voltage level at the common node 526 to reach a threshold switching voltage level of a comparator 528 after the early signal V_{E} is asserted.

If CK_{IN} and CK_{OUT} are aligned, as determined at step 608 (e.g., based on feedback from the phase detector 504), the DLL is considered locked, at step 610. Otherwise, the operations 600 return to step 606 to vary the one or more delay elements 524 coupled to the common node 526 of the current source 520. The operations 606-608 may be repeated, until CK_{IN} and CK_{OUT} are aligned. For some embodiments, fine adjustments may be made by initially coupling the one or more delay elements 524 to the common node 526 that result in the smallest delay (e.g., CK_{OUT} in phase with the early signal V_{E}), and changing the coupled delay elements 524 in each pass to increase the delay until CK_{IN} and CK_{OUT} are aligned.

### EXEMPLARY DLL BLENDER CIRCUITS

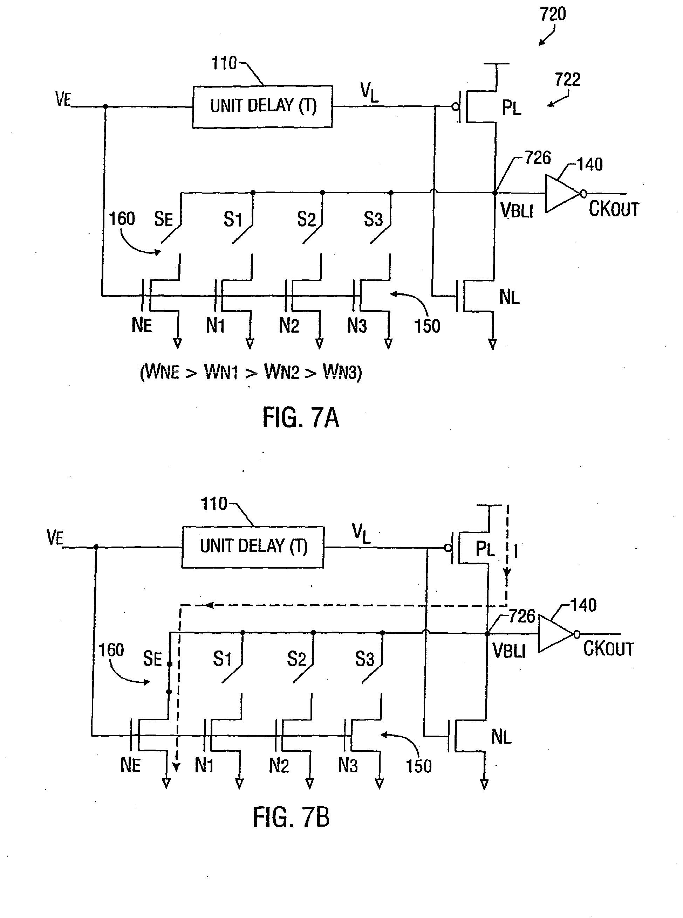

The delay elements 524 may comprise any suitable circuit components that affect the time between assertion of the early signal V_{E} and switching of the comparator 140. For example, as illustrated in FIG. 7A, a phase blender 720 may include one or more transistors 150 as delay elements. The transistors 150 may be coupled with a common node 726 of a current source 722 (a PMOS transistor PL) via one or more switches 160. For example, the one or more switches 160 may be opened or closed via signals generated by DLL control logic during fine phase adjustment (e.g., steps 606-608 of FIG. 6) of CK_{OUT}. The transistors 150 may vary the switching time of the comparator 140 by varying the effective resistance of the current path from the common node 726 when the early signal V_{E} is asserted.

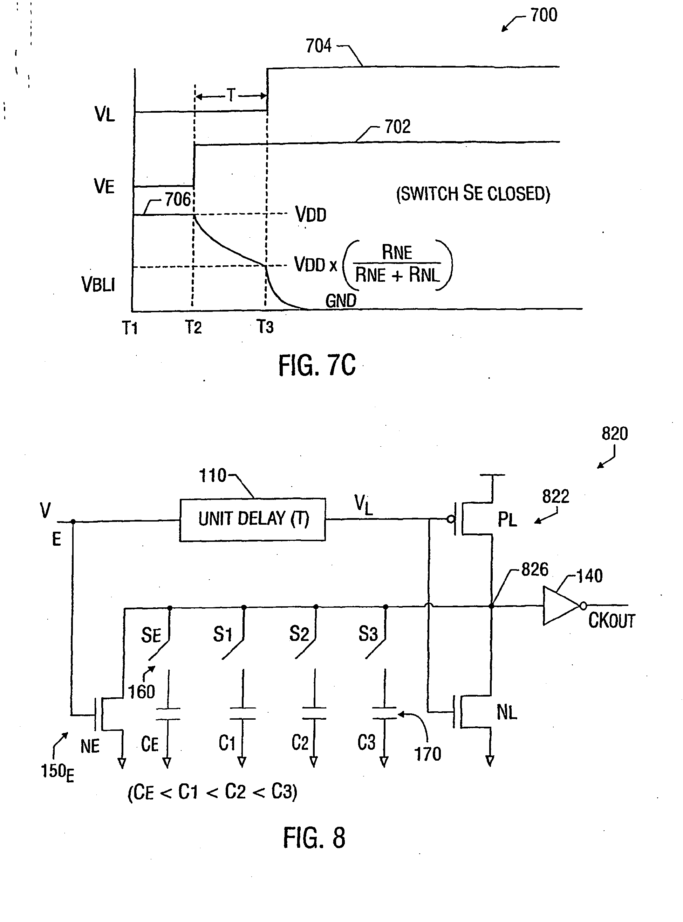

For example, FIG. 7B illustrates the phase blender 720 with the switch SE closed to provide a current path through transistor NE when the early phase signal V_{E} is asserted. FIG. 7C illustrates an exemplary timing diagram for the early signal V_{E} (702), the late signal V_{L} (704), and the (inverted) blended signal VBLI 706 when the switch SE is closed. As illustrated, at time T1, with both VE and VL de-asserted, there is no current path to ground and the common node 726 is precharged to VDD. When the early signal V_{E} is asserted (line 702) at time T2, NE provides a current path from the common node 726 to ground. Thus, prior to assertion of the late signal V_{L} at time T3, the voltage level of V_{BLI} is a function of the effective turn-on resistances of PL and NE. Once the late signal is asserted, PL is turned off and NL is turned on, and the common node 726 is discharged through both NE and NL.

Thus, the dimensions of PL, NL, and NE (as well as the output capacitance at the common node 726) will determine the time at which V_{BLI} crosses the switching threshold voltage of the comparator 140. Accordingly, the dimensions of PL, NL, and NE may be chosen in an effort to ensure CK_{OUT} is phase aligned with the early signal V_{E}, when switch SE is closed. For some embodiments, the dimensions of the transistors 150 may be chosen to vary the effective resistance of each transistor in an effort to generate CK_{OUT} having evenly distributed phases (e.g., every 90° corresponding to blended voltage signals shown in FIG. 3B).

In other words, the dimensions of N1-N3 may be chosen in an effort to ensure CK_{OUT} is phase delayed from the early signal V_{E} by 90°, 180°, and 270° when switches S1, S2, and S3 are closed, respectively. As illustrated, because effective transistor resistance is generally inversely proportional to channel width, the widths of the transistors may decrease from NE to N3 (e.g., NE = 2xN1 = 4xN2 = 8xN3). Of course, for some embodiments, multiple transistors 150 may be coupled to the common node concurrently to achieve the desired timing for any given phase delay. In other words, the dimensions of the transistors may be chosen such that the effective resistance of the transistors in parallel results in the desired switching time of the comparator 140.

By comparison, the circuit configuration of the DLL blender 720 has fewer components and is much simpler than the circuit configuration of the DLL blender 120 of FIG. 3A. As a result, it may be possible to provide finer adjustments (e.g., more than four blended phase signals) within the same or less circuit area. The additional blended phase signals may be provided by adding additional transistors 150 or by cascading multiple stages of blender circuits 720, for example, with each successive stage providing finer phase resolution. Further, by utilizing a single current source 722 and a single comparator 140, the DLL blender 720 may consume considerably less current than the conventional DLL blender 120.

As previously described, the switching time of the common node 726 of the current source 722 may also be determined by its output capacitance, which will generally include the input capacitance of the comparator 140 and any other capacitance on the common node 726. Thus, it may also be possible to vary the phase of CK_{OUT} by varying the capacitance of the common node 726.

FIG. 8 illustrates an exemplary DLL blender circuit 820 in which the capacitance at a common node 826 of a current source 822 is varied by selectively coupling one or more capacitors 170 thereto. In other words, the one or more capacitors 170 may be selectively coupled to vary the discharge rate of the common node 826 through NE when the early signal V_{E} is asserted, and through NE and NL when the late signal V_{L} is later asserted.

Thus, the size of the capacitors 170 (CE and C1-C3) may be chosen in an effort to ensure the time at which V_{BLI} crosses the switching threshold of the comparator 140 corresponds to the desired phase signals (e.g., V_{BLE} and V_{BL1}-V_{BL3} of FIG. 3B). As illustrated, to generate the earliest blended signal V_{BLE} (e.g., in phase with the early signal V_{E}), when switch SE is closed, CE may be the smallest capacitor 170. Similarly, the sizes of C1-C3 may be increased incrementally in an effort to ensure CK_{OUT} is phase delayed from the early signal V_{E} by 90°, 180°, and 270° when switches S1, S2, and S3 are closed, respectively. Of course, for some embodiments, multiple capacitors 170 may be coupled to the common node concurrently to achieve the desired timing for any given phase delay. In other words, the values of the capacitors 170 may be chosen such that the effective parallel capacitance (which is additive) results in the desired switching time of the comparator 140.

The capacitors 170 may be any suitable type of capacitors and the exact type may depend on the type used elsewhere on a device utilizing the blending circuit 820. For example, if the device is a DRAM device, the capacitors may be fabricated using the same type of process as capacitors of the memory cells (e.g., deep trench or stacked capacitors), which may reduce overall system cost. Further, for some embodiments, the delay elements of a phase blending circuit may include a combination of capacitors and transistors, which may be coupled to a common current source, in any suitable combination, to generate a plurality of phase blended signals as described herein.

### CONCLUSION

By selectively coupling one or more delay elements to a common node of a blending circuit, embodiments of the present invention may allow multiple blended signals differing in phase from one or more reference signals to be generated using a single current source. Thus, a phase blending circuit in accordance with embodiments of the present invention may be simpler to design and implement than conventional blending circuits utilizing one or more separate current source for each blended signal, and may also occupy less circuit area and consume less current.

While the foregoing is directed to embodiments of the present invention, other and further embodiments of the invention may be devised without departing from the basic scope thereof, and the scope thereof is determined by the claims that follow.

## Claims

1. A phase blending circuit (520; 720; 820) for generating a signal having a phase intermediate to phases of an early signal (V_{E}) and a late signal (V_{L}), comprising:
a comparator (140; 528);
a plurality of delay elements (524; N₁, N₂, N₃; C_{E}, C₁, C₂, C₃); and
a plurality of switches (S_{E}, S₁, S₂, S₃);
**characterized by**
a current source (522; 722; 822) having a common output node (526; 726; 826) and a control input for receiving the late phase signal (V_{L}) trailing the early phase signal (V_{E}), the current source (522; 722; 822) being adapted to be disabled when the late phase signal (V_{L}) is asserted; and
a path for current flow from the common output node (526; 726; 826) when the early phase signal (V_{E}) is asserted;
wherein the comparator (140; 528) has an input coupled with the common output node (526; 726; 826) of the current source (522; 722; 822),
wherein the plurality of switches (S_{E}, S₁, S₂, S₃) is adapted to selectively couple one or more of the delay elements (524; N₁, N₂, N₃; C_{E}, C₁, C₂, C₃) to the common output node (526; 726; 826) of the current source (522; 722; 822) for varying the time required for a voltage level of the common output node (526; 726; 826) to fall below a threshold switching level of the comparator (140; 528) as a result of current flow through the path, and
wherein the path for current flow comprises at least one switch (N_{E}) receiving the early phase signal (V_{E}) as a control input.

2. The phase blending circuit (720) of claim 1, **characterized in that** the at least one transistor (N_{E}) is one of the delay elements (N₁, N₂, N₃;) coupled to the common output node (726) of the current source (722) via one of the switches (S_{E}, S₁, S₂, S₃).

3. The phase blending circuit (720) of claim 1 or 2, **characterized in that** the at least one transistor (N_{E}) comprises an NMOS transistor and the current source (722) comprises a PMOS transistor (P_{L}).

4. The phase blending circuit (720) of one of claims 1 to 3, **characterized in that** the path for current flow further comprises at least one transistor (N_{L}) receiving the late phase signal (V_{L}) as an input.

5. The phase blending circuit (520; 720; 820) of one of claims 1 to 4, **characterized in that** the one or more delay elements (524; N₁, N₂, N₃; C_{E}, C₁, C₂, C₃) are configured to allow generation of a plurality of signals having phases separated by a substantially equal phase.

6. The phase blending circuit (720) of one claims 1 to 5, **characterized in that** the plurality of delay elements (N₁, N₂, N₃;) comprises a plurality of transistors having different dimensions.

7. The phase blending circuit (720) of claim 6, **characterized in that** the dimensions of the transistors are selected such that the phases of the plurality of signals are separated by a substantially equal phase.

8. The phase blending circuit (820) of one of claims 1 to 5, **characterized in that** the one or more delay elements (C_{E}, C₁, C₂, C₃) comprises at least one capacitor coupled with the common output node (826) of the current source (822).

9. The phase blending circuit (820) of claim 8, **characterized in that** the at least one capacitor comprises a plurality of capacitors having different values of capacitance.

10. The phase blending circuit (820) of claim 9, **characterized in that** the capacitor values are selected such that the phases of the plurality of signals are separated by a substantially equal phase.

11. A delay locked loop circuit (510) for generating an output signal aligned with an input signal, comprising:
a delay line (512) for providing phase signals delayed relative to the input signal by one or more of unit delays; and a control logic (504);
**characterized by**
a phase blending circuit (520; 720; 820) of one of claims 1 to 10 for generating a blended phase signal having a phase between early and late phase signals (V_{L}) provided by the delay line;
wherein the control logic (504) is configured to monitor skew between the input and output signals (CK_{IN}, CK_{OUT}) and, based on the skew, generate one or more control signals to select the early and late signals (V_{E}, V_{L}) provided to the phase blending circuit (520; 720; 820) and to selectively couple one or more of the delay elements (524; N₁, N₂, N₃; C_{E}, C₁, C₂, C₃) to the common output node (526; 726; 826).

12. The delay locked loop circuit of claim 11, **characterized in that** the control logic (504) is further configured to:
(a) determine if the input and output signals are aligned within an accepted tolerance;
(b) if not, modify the one or more control signals to couple a different one or more of the delay elements (524; N₁, N₂, N₃; C_{E}, C₁, C₂, C₃) to the common output node (526; 726; 826); and
(c) repeat steps (a)-(b) until the input and output signals are aligned within the accepted tolerance.

13. A dynamic random access memory (DRAM) device (500), comprising:
one or more memory elements (540);
**characterized by**
a delay locked loop circuit (510) of claim 11 or 12 for synchronizing data output from the one or more memory elements (540) with a clock signal.

14. The DRAM device of claim 13, **characterized in that** the plurality of capacitors of the blending circuit (520; 720; 820) are of the same type as capacitors utilized in the memory elements (540).

15. A method for generating a signal having a phase intermediate to phases of an early signal (V_{E}) and a late signal (V_{L}), **characterized by**:
coupling the early signal (V_{E}) to a control input of one or more switches (N_{E}) to provide a path for current flow from a common output node (526; 726; 826) of a current source (522; 722; 822) through the one or more switches (N_{E}) when the early signal (V_{E}) is asserted;
closing one or more switches (S_{E}, S₁, S₂, S₃) to selectively couple one or more delay elements (524; N₁, N₂, N₃; C_{E}, C₁, C₂, C₃) to the common output node (526; 726; 826) of the current source (522; 722; 822), wherein a time required for a voltage level of the common output node (526; 726; 826) to fall below a threshold switching level of a comparator (140; 528) coupled with the common output node (526; 726; 826) of the current source (522; 722; 822) as a result of the current flow is dependent on which of the one or more switches (S_{E}, S₁, S₂, S₃) are closed; and
coupling the late signal (V_{L}) to a control input of the current source (522; 722; 822) to disable the current source (522; 722; 822) when the late signal (V_{L}) is asserted.

16. The method of claim 15, **characterized in that** the one or more delay elements (N₁, N₂, N₃) comprise one or more transistors.

17. The method of claim 16, **characterized in that** the one or more switches (S_{E}, S₁, S₂, S₃) comprise the one or more transistors.

18. The method of claim 15, **characterized in that** the one or more delay elements (C_{E}, C₁, C₂, C₃) comprise one or more capacitors.

19. The method of one of claims 15 to 18, **characterized in that**:
the late signal trails the early signal by a unit delay; and
the switches (S_{E}, S₁, S₂, S₃) and delay elements (524; N₁, N₂, N₃;C_{E}, C₁, C₂, C₃) are configured to provide the delayed signal differing in phase from the early signal by a fraction of the unit delay, wherein the fraction depends on which of the switches (S_{E}, S₁, S₂, S₃) are closed.

## Patentansprüche

1. Eine Phasenmischschaltung (520; 720; 820) zum Erzeugen eines Signals, das eine Phase zwischen Phasen eines Frühsignals (V_{E}) und eines Spätsignals (V_{L}) aufweist, die folgende Merkmale aufweist:
einen Komparator (140; 528);
eine Mehrzahl von Verzögerungselementen (524; N₁, N₂, N₃; C_{E}, C₁, C₂, C₃); und
eine Mehrzahl von Schaltern (S_{E}, S₁, S₂, S₃);
**gekennzeichnet durch**
eine Stromquelle (522; 722; 822), die einen gemeinsamen Ausgangsknoten (526; 726; 826) und einen Steuereingang zum Empfangen des Spätphasensignals (V_{L}), das dem Frühphasensignal (V_{E}) nacheilt, aufweist, wobei die Stromquelle (522; 722; 822) angepasst ist, um gesperrt zu werden, wenn das Spätphasensignal (V_{L}) aktiviert ist; und
einen Weg für einen Stromfluss von dem gemeinsamen Ausgangsknoten (526; 726; 826), wenn das Frühphasensignal (V_{E}) aktiviert ist;
wobei der Komparator (140; 528) einen Eingang aufweist, der mit dem gemeinsamen Ausgangsknoten (526; 726; 826) der Stromquelle (522; 722; 822) gekoppelt ist,
wobei die Mehrzahl von Schaltern (S_{E}, S₁, S₂, S₃) angepasst ist, um eines oder mehr der Verzögerungselemente (524; N₁, N₂, N₃; C_{E}, C₁, C₂, C₃) selektiv mit dem gemeinsamen Ausgangsknoten (526; 726; 826) der Stromquelle (522; 722; 822) zu koppeln, zum Variieren der Zeit, die benötigt wird, damit ein Spannungspegel des gemeinsamen Ausgangsknotens (526; 726; 826) infolge eines Stromflusses **durch** den Weg unter einen Schwellenschaltpegel des Komparators (140; 528) fällt, und
wobei der Weg für einen Stromfluss zumindest einen Schalter (N_{E}) aufweist, der das Frühphasensignal (V_{E}) als einen Steuereingang empfängt.

2. Die Phasenmischschaltung (720) gemäß Anspruch 1, **dadurch gekennzeichnet, dass** der zumindest eine Transistor (N_{E}) eines der Verzögerungselemente (N₁, N₂, N₃) ist, die über einen der Schalter (S_{E}, S₁, S₂, S₃) mit dem gemeinsamen Ausgangsknoten (726) der Stromquelle (722) gekoppelt sind.

3. Die Phasenmischschaltung (720) gemäß Anspruch 1 oder 2, **dadurch gekennzeichnet, dass** der zumindest eine Transistor (N_{E}) einen NMOS-Transistor aufweist, und die Stromquelle (722) einen PMOS-Transistor (P_{L}) aufweist.

4. Die Phasenmischschaltung (720) gemäß einem der Ansprüche 1 bis 3, **dadurch gekennzeichnet, dass** der Weg für einen Stromfluss ferner zumindest einen Transistor (N_{L}) aufweist, der das Spätphasensignal (V_{L}) als ein Eingangssignal empfängt.

5. Die Phasenmischschaltung (520; 720; 820) gemäß einem der Ansprüche 1 bis 4, **dadurch gekennzeichnet, dass** die ein oder mehr Verzögerungselemente (524; N₁, N₂, N₃; C_{E}, C₁, C₂, C₃) konfiguriert sind, um eine Erzeugung einer Mehrzahl von Signalen zu ermöglichen, die Phasen aufweisen, die durch eine im Wesentlichen gleiche Phase getrennt sind.

6. Die Phasenmischschaltung (720) gemäß einem der Ansprüche 1 bis 5, **dadurch gekennzeichnet, dass** die Mehrzahl von Verzögerungselementen (N₁, N₂, N₃) eine Mehrzahl von Transistoren aufweist, die unterschiedliche Abmessungen aufweisen.

7. Die Phasenmischschaltung (720) gemäß Anspruch 6, **dadurch gekennzeichnet, dass** die Abmessungen der Transistoren derart ausgewählt sind, dass die Phasen der Mehrzahl von Signalen durch eine im Wesentlichen gleiche Phase getrennt sind.

8. Die Phasenmischschaltung (820) gemäß einem der Ansprüche 1 bis 5, **dadurch gekennzeichnet, dass** die ein oder mehr Verzögerungselemente (C_{E}, C₁, C₂, C₃) zumindest einen Kondensator aufweisen, der mit dem gemeinsamen Ausgangsknoten (826) der Stromquelle (822) gekoppelt ist.

9. Die Phasenmischschaltung (820) gemäß Anspruch 8, **dadurch gekennzeichnet, dass** der zumindest eine Kondensator eine Mehrzahl von Kondensatoren aufweist, die unterschiedliche Kapazitätswerte aufweisen.

10. Die Phasenmischschaltung (820) gemäß Anspruch 9, **dadurch gekennzeichnet, dass** die Kondensatorwerte derart ausgewählt sind, dass die Phasen der Mehrzahl von Signalen durch eine im Wesentlichen gleiche Phase getrennt sind.

11. Eine Verzögerungsregelschleifenschaltung (510) zum Erzeugen eines Ausgangssignals, das mit einem Eingangssignal ausgerichtet ist, die folgende Merkmale aufweist:
eine Verzögerungsleitung (512) zum Liefern von Phasensignalen, die relativ zu dem Eingangssignal um eine oder mehr von Einheitsverzögerungen verzögert sind; und
eine Steuerlogik (504);
**gekennzeichnet durch**
eine Phasenmischschaltung (520; 720; 820) gemäß einem der Ansprüche 1 bis 10 zum Erzeugen eines Mischphasensignals, das eine Phase zwischen Früh- und Spätphasensignalen (V_{L}) aufweist, die **durch** die Verzögerungsleitung geliefert werden;
wobei die Steuerlogik (504) konfiguriert ist, um einen Versatz zwischen den Eingangs- und Ausgangssignalen (CK_{IN}, CK_{OUT}) zu überwachen und basierend auf dem Versatz ein oder mehr Steuersignale zu erzeugen, um die Früh- und Spätsignale (V_{E}, V_{L}) auszuwählen, die an die Phasenmischschaltung (520; 720; 820) geliefert werden, und um eines oder mehr der Verzögerungselemente (524; N₁, N₂, N₃; C_{E}, C₁, C₂, C₃) selektiv mit dem gemeinsamen Ausgangsknoten (526; 726; 826) zu koppeln.

12. Die Verzögerungsregelschleifenschaltung gemäß Anspruch 11, **dadurch gekennzeichnet, dass** die Steuerlogik (504) ferner konfiguriert ist, um:
(a) zu bestimmen, ob die Eingangs- und Ausgangssignale innerhalb einer akzeptierten Toleranz ausgerichtet sind;
(b) andernfalls die ein oder mehr Steuersignale zu modifizieren, um andere ein oder mehr Verzögerungselemente (524; N₁, N₂, N₃; C_{E}, C₁, C₂, C₃) mit dem gemeinsamen Ausgangsknoten (526; 726; 826) zu koppeln; und
(c) die Schritte (a) - (b) zu wiederholen, bis die Eingangs- und Ausgangssignale innerhalb der akzeptierten Toleranz ausgerichtet sind.

13. Eine Dynamischer-Direktzugriffsspeicher- (DRAM-) Vorrichtung (500), die folgende Merkmale aufweist:
ein oder mehr Speicherelemente (540);
**gekennzeichnet durch**
eine Verzögerungsregelschleifenschaltung (510) gemäß Anspruch 11 oder 12 zum Synchronisieren einer Datenausgabe von den ein oder mehr Speicherelementen (540) mit einem Taktsignal.

14. Die DRAM-Vorrichtung gemäß Anspruch 13, **dadurch gekennzeichnet, dass** die Mehrzahl von Kondensatoren der Mischschaltung (520; 720; 820) von dem gleichen Typ ist wie Kondensatoren, die bei den Speicherelementen (540) verwendet werden.

15. Ein Verfahren zum Erzeugen eines Signals, das eine Phase zwischen Phasen eines Frühsignals (V_{E}) und eines Spätsignals (V_{L}) aufweist, **gekennzeichnet durch**:
Koppeln des Frühsignals (V_{E}) mit einem Steuereingang von ein oder mehr Schaltern (N_{E}), um einen Weg für einen Stromfluss von einem gemeinsamen Ausgangsknoten (526; 726; 826) einer Stromquelle (522; 722; 822) durch die ein oder mehr Schalter (N_{E}) zu liefern, wenn das Frühsignal (V_{E}) aktiviert ist;
Schließen von ein oder mehr Schaltern (S_{E}, S₁, S₂, S₃), um ein oder mehr Verzögerungselemente (524; N₁, N₂, N₃; C_{E}, C₁, C₂, C₃) selektiv mit dem gemeinsamen Ausgangsknoten (526; 726; 826) der Stromquelle (522; 722; 822) zu koppeln, wobei eine Zeit, die benötigt wird, damit ein Spannungspegel des gemeinsamen Ausgangsknotens (526; 726; 826) infolge des Stromflusses unter einen Schwellenschaltpegel eines Komparators (140; 528) fällt, der mit dem gemeinsamen Ausgangsknoten (526; 726; 826) der Stromquelle (522; 722; 822) gekoppelt ist, davon abhängt, welche der ein oder mehr Schalter (S_{E}, S₁, S₂, S₃) geschlossen sind; und
Koppeln des Spätsignals (V_{L}) mit einem Steuereingang der Stromquelle (522; 722; 822), um die Stromquelle (522; 722; 822) zu sperren, wenn das Spätsignal (V_{L}) aktiviert ist.

16. Das Verfahren gemäß Anspruch 15, **dadurch gekennzeichnet, dass** die ein oder mehr Verzögerungselemente (N₁, N₂, N₃) ein oder mehr Transistoren aufweisen.

17. Das Verfahren gemäß Anspruch 16, **dadurch gekennzeichnet, dass** die ein oder mehr Schalter (S_{E}, S₁, S₂, S₃) die ein oder mehr Transistoren aufweisen.

18. Das Verfahren gemäß Anspruch 15, **dadurch gekennzeichnet, dass** die ein oder mehr Verzögerungselemente (C_{E}, C₁, C₂, C₃) ein oder mehr Kondensatoren aufweisen.

19. Das Verfahren gemäß einem der Ansprüche 15 bis 18, **dadurch gekennzeichnet, dass**:
das Spätsignal dem Frühsignal um eine Einheitsverzögerung nacheilt; und
die Schalter (S_{E}, S₁, S₂, S₃) und die Verzögerungselemente (524; N₁, N₂, N₃; C_{E}, C₁, C₂, C₃) konfiguriert sind, um das verzögerte Signal zu liefern, das sich bezüglich der Phase von dem Frühsignal um einen Bruchteil der Einheitsverzögerung unterscheidet, wobei der Bruchteil davon abhängt, welche der Schalter (S_{E}, S₁, S₂, S₃) geschlossen sind.

## Revendications

1. Circuit mélangeur de phase (520 ; 720 ; 820) destiné à générer un signal ayant une phase intermédiaire entre les phases d'un signal précoce (V_{E}) et d'un signal tardif (V_{L}), comprenant :
un comparateur (140 ; 528) ;
une pluralité d'éléments de temporisation (524; N₁, N₂, N₃; C_{E}, C₁, C₂, C₃) ; et
une pluralité de commutateurs (S_{E}, S₁, S₂, S₃) ;
**caractérisé par**
une source de courant (522 ; 722 ; 822) présentant un noeud de sortie commun (526 ; 726 ; 826) et une entrée de commande destinée à recevoir le signal de phase tardif (V_{L}) en retard sur le signal de phase précoce (V_{E}), la source de courant (522 ; 722 ; 822) étant adaptée pour être désactivée lorsque le signal de phase tardif (V_{L}) est affirmé ; et
un trajet de circulation de courant à partir du noeud de sortie commun (526 ; 726 ; 826) lorsque le signal de phase précoce (V_{E}) est affirmé ;
dans lequel le comparateur (140 ; 528) présente une entrée couplée au noeud de sortie commun (526 ; 726 ; 826) de la source de courant (522 ; 722 ; 822),
dans lequel la pluralité de commutateurs (S_{E}, S₁, S₂, S₃) sont adaptés pour coupler sélectivement un ou plusieurs des éléments de temporisation (524; N₁, N₂, N₃ ; C_{E}, C₁, C₂, C₃) au noeud de sortie commun (526 ; 726 ; 826) de la source de courant (522 ; 722 ; 822) pour faire varier le temps requis pour qu'un niveau de tension du noeud de sortie commun (526 ; 726 ; 826) tombe au-dessous d'un niveau de commutation de seuil du comparateur (140 ; 528) par suite de la circulation de courant dans le trajet, et
dans lequel le trajet de circulation de courant comprend au moins un commutateur (N_{E}) recevant le signal de phase précoce (V_{E}) comme entrée de commande.

2. Circuit mélangeur de phase (720) selon la revendication 1, **caractérisé par le fait que** l'au moins un transistor (N_{E}) est l'un des éléments de temporisation (N₁, N₂, N₃) couplés au noeud de sortie commun (726) de la source de courant (722) par l'intermédiaire de l'un des commutateurs (S_{E}, S₁, S₂, S₃).

3. Circuit mélangeur de phase (720) selon la revendication 1 ou 2, **caractérisé par le fait que** l'au moins un transistor (N_{E}) comprend un transistor NMOS et que la source de courant (722) comprend un transistor PMOS (P_{L}).

4. Circuit mélangeur de phase (720) selon l'une des revendications 1 à 3, **caractérisé par le fait que** le trajet de circulation de courant comprend, par ailleurs, au moins un transistor (N_{L}) recevant le signal de phase tardif (V_{L}) comme entrée.

5. Circuit mélangeur de phase (520 ; 720 ; 820) selon l'une des revendications 1 à 4, **caractérisé par le fait que** l'un ou les plusieurs éléments de temporisation (524 ; N₁, N₂, N₃ ; C_{E}, C₁, C₂, C₃) sont configurés de manière à permettre la génération d'une pluralité de signaux ayant des phases séparées par une phase sensiblement égale.

6. Circuit mélangeur de phase (720) selon l'une des revendications 1 à 5, **caractérisé par le fait que** la pluralité d'éléments de temporisation (N₁, N₂, N₃) comprend une pluralité de transistors présentant des dimensions différentes.

7. Circuit mélangeur de phase (720) selon la revendication 6, **caractérisé par le fait que** les dimensions des transistors sont choisies de sorte que les phases de la pluralité de signaux soient séparées par une phase sensiblement égale.

8. Circuit mélangeur de phase (820) selon l'une des revendications 1 à 5, **caractérisé par le fait que** l'un ou les plusieurs éléments de temporisation (C_{E}, C₁, C₂, C₃) comprend au moins un condensateur couplé au noeud de sortie commun (826) de la source de courant (822).

9. Circuit mélangeur de phase (820) selon la revendication 8, **caractérisé par le fait que** l'au moins un condensateur comprend une pluralité de condensateurs ayant des valeurs de capacité différentes.

10. Circuit mélangeur de phase (820) selon la revendication 9, **caractérisé par le fait que** les valeurs de condensateur sont choisies de sorte que les phases de la pluralité de signaux soient séparées par une phase sensiblement égale.

11. Circuit à boucle à verrouillage retardé (510) destiné à générer un signal de sortie aligné sur un signal d'entrée, comprenant :
une ligne de temporisation (512) destinée à fournir des signaux de phase retardés par rapport au signal d'entrée d'une ou de plusieurs unités de retard ; et
une logique de commande (504);
**caractérisé par**
un circuit mélangeur de phase (520 ; 720 ; 820) selon l'une des revendications 1 à 10 destiné à générer un signal de phase mélangé ayant une phase entre le signal de phase précoce et le signal de phase tardif (V_{L}) fournie par la ligne de temporisation ;
dans lequel la logique de commande (504) est configurée de manière à surveiller l'obliquité entre les signaux d'entrée et de sortie (CK_{IN}, CK_{OUT}) et à générer, sur base de l'obliquité, un ou plusieurs signaux de commande pour sélectionner les signaux précoce et tardif (V_{E}, V_{L}) fournis au circuit mélangeur de phase (520 ; 720 ; 820) et pour coupler sélectivement un ou plusieurs des éléments de temporisation (524; N₁, N₂, N₃; C_{E}, C₁, C₂, C₃) au noeud de sortie commun (526 ; 726 ; 826).

12. Circuit à boucle à verrouillage retardé selon la revendication 11, **caractérisé par le fait que** la logique de commande (504) est, par ailleurs, configurée de manière à :
(a) déterminer si les signaux d'entrée et de sortie sont alignés dans les limites d'une tolérance acceptée ;
(b) dans la négative, modifier l'un ou les plusieurs signaux de commande, pour coupler un ou plusieurs différents des éléments de temporisation (524; N₁, N₂, N₃; C_{E}, C₁, C₂, C₃) au noeud de sortie commun (526 ; 726 ; 826) ; et
(c) répéter les étapes (a) et (b) jusqu'à ce que les signaux d'entrée et de sortie soient alignés dans les limites de la tolérance acceptée.

13. Dispositif de mémoire vive dynamique (DRAM) (500), comprenant :
un ou plusieurs éléments de mémoire (540) ;
**caractérisé par**
un circuit à boucle à verrouillage retardé (510) selon la revendication 11 ou 12, destiné à synchroniser les données de sortie de l'un ou des plusieurs éléments de mémoire (540) avec un signal d'horloge.

14. Dispositif DRAM selon la revendication 13, **caractérisé par le fait que** la pluralité de condensateurs du circuit mélangeur (520 ; 720 ; 820) sont du même type que les condensateurs utilisés dans les éléments de mémoire (540).

15. Procédé pour générer un signal ayant une phase intermédiaire entre les phases d'un signal précoce (V_{E}) et un signal tardif (V_{L}), **caractérisé par** :
coupler le signal de phase précoce (V_{E}) à une entrée de commande d'un ou plusieurs commutateurs (NE), pour créer un trajet de circulation de courant d'un noeud de sortie commun (526 ; 726 ; 826) d'une source de courant (522 ; 722 ; 822) à travers l'un ou les plusieurs commutateurs (N_{E}) lorsque le signal de phase précoce (V_{E}) est affirmé;
fermer un ou plusieurs commutateurs (S_{E}, S₁, S₂, S₃), pour coupler sélectivement un ou plusieurs éléments de temporisation (524; N₁, N₂, N₃; C_{E}, C₁, C₂, C₃) au noeud de sortie commun (526 ; 726 ; 826) de la source de courant (522 ; 722 ; 822), dans lequel un temps requis pour qu'un niveau de tension du noeud de sortie commun (526 ; 726 ; 826) tombe au-dessous d'un niveau de commutation de seuil d'un comparateur (140 ; 528) couplé au noeud de sortie commun (526 ; 726 ; 826) de la source de courant (522 ; 722 ; 822) par suite de la circulation de courant est fonction de ceux parmi l'un ou les plusieurs commutateurs (S_{E}, S₁, S₂, S₃) qui sont fermés ; et
coupler le signal tardif (V_{L}) à une unité de commande de la source de courant (522 ; 722 ; 822), pour désactiver la source de courant (522 ; 722 ; 822) lorsque le signal tardif (V_{L}) est affirmé.

16. Procédé selon la revendication 15, **caractérisé par le fait que** l'un ou les plusieurs éléments de temporisation (N₁, N₂, N₃) comprennent un ou plusieurs transistors.

17. Procédé selon la revendication 16, **caractérisé par le fait que** l'un ou les plusieurs commutateurs (S_{E}, S₁, S₂, S₃) comprennent l'un ou les plusieurs transistors.

18. Procédé selon la revendication 15, **caractérisé par le fait que** l'un ou les plusieurs éléments de temporisation (C_{E}, C₁, C₂, C₃) comprennent un ou plusieurs condensateurs.

19. Procédé selon l'une des revendications 15 à 18, **caractérisé par le fait que** :
le signal tardif est en retard sur le signal précoce d'un retard d'une unité ; et
les commutateurs (S_{E}, S₁, S₂, S₃) et les éléments de temporisation (524 ; N₁, N₂, N₃ ; C_{E}, C₁, C₂, C₃) sont configurés de manière à fournir le signal retardé différant en phase du signal précoce d'une fraction du retard unitaire, dans lequel la fraction est fonction des commutateurs (S_{E}, S₁, S₂, S₃) qui sont fermés.
